# FASCICULE DE BREVET EUROPEEN

(11) **EP 0 562 091 B1**
(45) Date de publication et mention de la délivrance du brevet: **14.06.1995**
(21) Numéro de dépôt: 92921789.1
(22) Date de dépôt: 06.10.1992
(51) Int. Cl.: H03H 7/01

(54) **FILTRE ELECTRIQUE HAUTE FREQUENCE D'ORDRE QUELCONQUE**
Elektrisches Hochfrequenzfilter mit beliebiger Ordnung
HIGH-FREQUENCY ELECTRIC FILTER OF ANY ORDER

(30) Priorité: 15.10.1991 FR 9112667
(43) Date de publication de la demande: 29.09.1993
(73) Titulaire: THOMSON-CSF, 75008 Paris (FR)
(72) Inventeur: RENVOISE, Yves, F-92045 Paris-La Défense Cédex 67 (FR)
(74) Mandataire: Lincot, Georges
(86) Numéro de dépôt international: FR9200925
(87) Numéro de publication internationale: WO9308640

(56) Documents cités:
- NL-A- 6 409 317
- PATENT ABSTRACTS OF JAPAN vol. 7, no. 80 (E-168)(1225) 2 Avril 1983

## Description

La présente invention concerne un filtre électrique haute fréquence d'ordre quelconque qui se rapporte au domaine des hautes fréquences (HF, VHF, UHF).

Elle trouve notamment son application à la réalisation de postes émetteurs-récepteurs radioélectriques.

Les filtres haute fréquence sont généralement obtenues par un assemblage de composants électroniques à piquer ou en CMS, abréviation de "Composants Montés en Surface" de type condensateurs, résistances ou semi-conducteurs, etc..., et de bobines réalisées en fil autour d'un mandrin ou pot, ou bien de bobines imprimées sur un substrat. Dans le cas ou les bobines sont réalisées en fil, le câblage manuel délicat ainsi que l'assemblage sur un support deviennent des inconvénients. De plus une telle solution devient vite encombrante dans le cas de circuit à multiples bobines. Pour les bobines imprimées sur un substrat, le coefficient de qualité ou surtension de la bobine est lié à son volume. Celui-ci est d'autant plus grand que le coefficient de qualité est élevé. Afin d'éviter tout couplage avec le blindage extérieur qui entoure généralement ces circuits, un écartement de la bobine imprimée par rapport à celui-ci est nécessaire ce qui accroît encore l'encombrement total du circuit .

Le but de l'invention est de pallier les inconvénients précités.

A cet effet l'invention a pour objet un filtre électrique haute fréquence d'ordre quelconque, caractérisé en ce qu'il comporte d'une part, une ou plusieurs bobines formées par un conducteur unique enroulé autour d'une même plaque de circuit imprimé et d'autre part, des composants fixés à la plaque de circuit imprimé et connectés par au moins une de leurs extrémités au conducteur unique.

D'autres caractéristiques et avantages de l'invention apparaîtront à la lecture de la description qui suit faite en regard des dessins annexés qui représentent :
- figure 1 : une bobine élémentaire entrant dans la composition d'un filtre selon l'invention ;
- figure 2 : une mise en série de deux bobines disposées bout à bout sur une même plaque isolante ;
- figure 3 : une réalisation d'un filtre complet composé de trois bobines issues d'un même fil enroulé autour d'un circuit imprimé ;
- figure 4 : une bobine élémentaire dérivée de celle représentée à la figure 1 dont le fil constituant la bobine est remplacé par une piste imprimée.

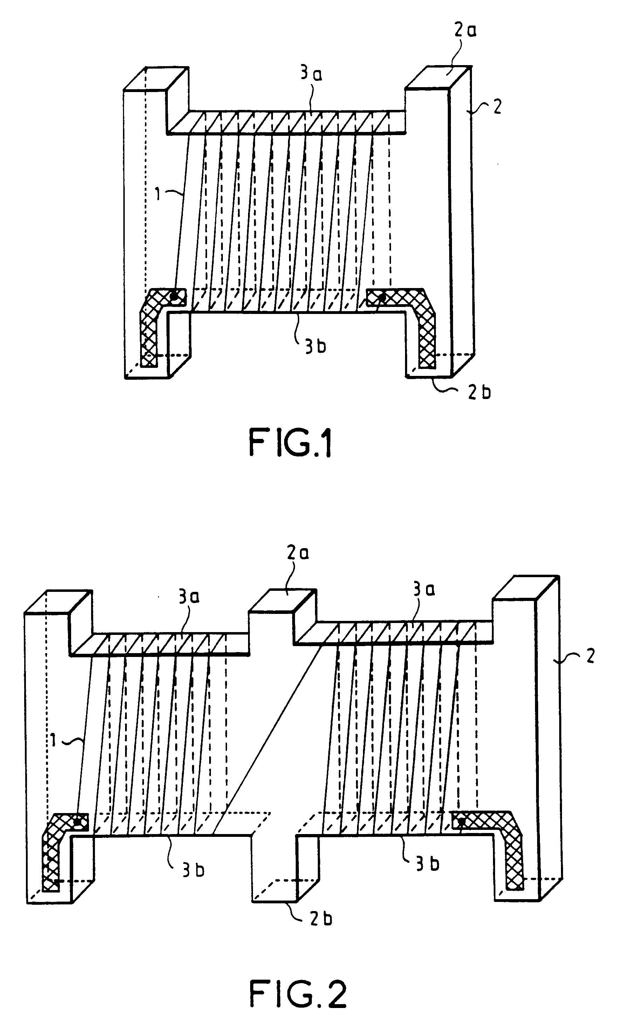

Une bobine élémentaire entrant dans la composition d'un filtre selon l'invention comporte de la façon représentée à la figure 1, un fil de cuivre 1 enroulé autour d'une plaque isolante 2 dans un espace formé par deux encoches 3a et 3b entaillées respectivement sur deux bords opposés 2a et 2b de la plaque 2 et s'étendant suivant une direction perpendiculaire aux plans de spires formées par le fil de cuivre 1. La bobine à section rectangulaire et de faible épaisseur qui est ainsi obtenue a principalement pour avantage de réduire au maximum l'influence sur le coefficient de surtension de la bobine des blindages extérieurs habituellement utilisés dans le domaine des hautes fréquences. D'autre part, le champ rayonné à l'extérieur dans l'axe de la bobine perpendiculaire au plan des spires est relativement faible et permet d'envisager comme le montre le mode de réalisation de la figure 2 des montages en série de plusieurs bobines sur une même plaque 2 avec des coefficients de mutuelle inductance relativement faibles. Les avantages sont alors une plus grande maîtrise dans le calcul et la réalisation des filtres passifs haute fréquence, ainsi qu'une diminution de leur encombrement.

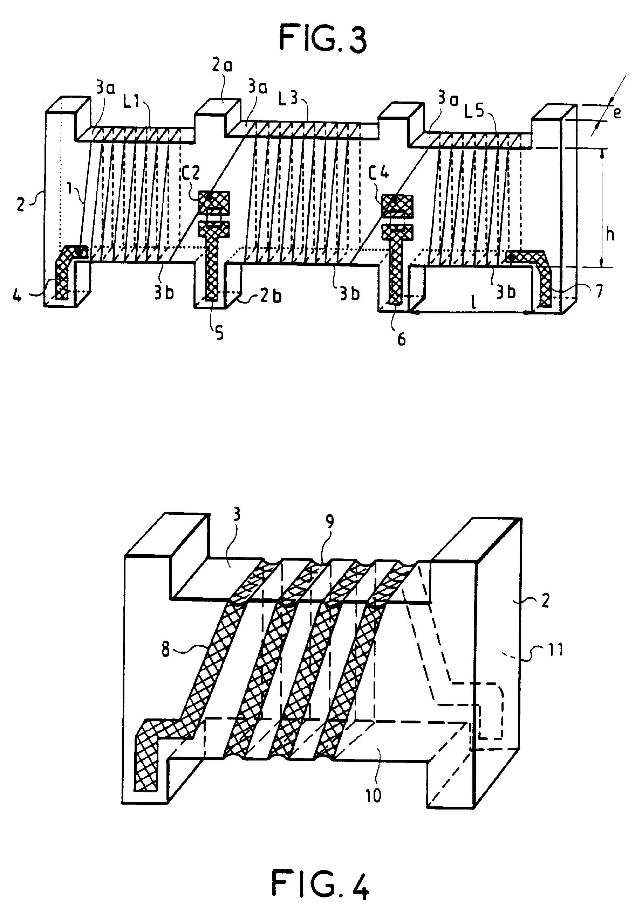

Un autre avantage résultant aussi de la structure représentée à la figure 2 est qu'elle permet la réalisation comme le montre la figure 3 de filtres comportant plusieurs bobines en série au moyen d'un seul fil 1 enroulé en une seule opération autour d'une plaque de circuit imprimé 2 passant par les points de liaison des bobines avec les autres composants C2, C4 du circuit imprimé nécessaires à la formation du filtre. Comme sur les figures 1 et 2, la plaque isolante 2 est avantageusement aménagée d'encoches 3a, 3b de largeur 1 définissant l'espace de bobinage nécessaire et des hauteurs h respectives à chaque bobine. L'épaisseur e et la hauteur h de la plaque 2, la largeur 1 de l'encoche et le nombre de spires déterminent la valeur de l'inductance de chaque bobine. Selon la figure 3, pour former le filtre deux condensateurs C2 et C4 sont soudés sur le circuit imprimé 2. Des plages métallisées 4, 5, 6 et 7 permettent le raccordement du filtre à une carte mère extérieure non représentée.

Naturellement, l'invention n'est pas limitée aux filtres qui viennent d'être décrits. Suivant un autre mode de réalisation illustré à la figure 4, le fil 1 peut être avantageusement remplacé par une piste imprimée 8 entourant la plaque 2. Les spires de la ou des bobines peuvent alors être réalisées en deux demi- spires gravées, l'une sur la face avant 10 de la plaque 2 et l'autre sur la face arrière 11 de la plaque 2, les deux demi-spires étant par exemple reliées par des trous métallisés 9.

La présente invention peut s'étendre à tout autre filtre comportant une ou des bobines compatibles aux gammes de fréquence HF, VHF et UHF en utilisant pour la plaque isolante le matériau diélectrique qui convient la mieux : polyimide, téflon, etc... Il est possible également de reporter sur un même circuit imprimé des fonctions complémentaires à la fonction de filtrage telles que : commutation entrée-sortie, amplification à base de composants en CMS, etc... La mise en série de plusieurs filtres différents dans un espace réduit est également possible. Naturellement pour adapter les dimensions du filtre à la puissance dissipée désirée, il est conseillé d'augmenter les dimensions du filtre, à l'inverse pour des puissances faibles celles-ci peuvent être diminuées en réduisant le diamètre du fil ou la largeur des pistes imprimées ainsi que les dimensions de la plaque et des autres composants entrant dans la composition du filtre.

## Revendications

1. Filtre électrique haute fréquence d'ordre quelconque, caractérisé en ce qu'il comporte d'une part, une ou plusieurs bobines formées par un conducteur unique (1 ; 8) enroulé autour d'une même plaque de circuit imprimé (2) et d'autre part, des composants capacitifs fixés à la plaque de circuit imprimé (2) et connectés par au moins une de leurs extrémités au conducteur unique (1 ; 8).

2. Filtre, selon la revendication 1, caractérisé en ce que la ou les bobines sont constituées d'un fil de cuivre émaillé (1) dont le bobinage autour de la plaque de circuit imprimé (2) s'effectue en une seule opération en le faisant passer par des plots de liaison avec les autres composants du filtre fixés au circuit imprimé.

3. Filtre, selon la revendication 1, caractérisé en ce que les spires (8) de la ou des bobines sont réalisées en deux demi-spires gravées, l'une sur la face avant (10) de la plaque de circuit imprimé (2) et l'autre sur sa face arrière (11) et en ce que les deux demi-spires (8) sont reliées par des trous métallisés (9).

4. Filtre, selon l'une quelconque des revendications 2 et 3, caractérisé en ce qu'il présente d'une part des encoches (3a, 3b) entaillées sur chaque bord (2a, 2b) de la plaque de circuit imprimé (2) définissant l'espace de câblage de la ou des bobines et d'autre part que ces encoches (2a, 2b) forment des parties avancées de la plaque (2) par lesquelles des connexions extérieures au filtre sont effectuées par l'intermédiaire de plages métallisées (4, 5, 6, 7) gravées sur les parties avancées.

## Patentansprüche

1. Elektrisches Hochfrequenzfilter beliebiger Ordnung, dadurch gekennzeichnet, daß es einerseits eine oder mehrere Spulen, die durch einen einzigen, um eine gleiche Leiterplatte (2) gewickelten Leiter (1; 8) gebildet sind, und andererseits kapazitive Bauteile enthält, die an der Leiterplatte (2) befestigt und mit wenigstens einem ihrer Enden mit dem einzigen Leiter (1; 8) verbunden sind.

2. Filter nach Anspruch 1, dadurch gekennzeichnet, daß die Spulen durch einen emaillierten Kupferdraht (1) gebildet sind, der in einem einzigen Arbeitsgang um die Leiterplatte (2) gewickelt ist, indem er über Kontakte für eine Verbindung mit den anderen, an der Leiterplatte befestigten Bauteilen des Filters geführt ist.

3. Filter nach Anspruch 1, dadurch gekennzeichnet, daß die Windungen (8) der Spule oder der Spulen aus zwei geätzten Halbwindungen gebildet sind, wobei die eine auf der Vorderseite (10) der Leiterplatte (2) und die andere auf der Rückseite (11) vorgesehen ist, und daß die beiden Halbwindungen (8) durch metallisierte Löcher (9) verbunden sind.

4. Filter nach einem der Ansprüche 2 und 3, dadurch gekennzeichnet, daß es einerseits an jedem Rand (2a, 2b) der Leiterplatte (2) eingebrachte Einschnitte (3a, 3b) aufweist, die den Raum für ein Verlegen der Spule oder der Spulen festlegen, und daß andererseits diese Einschnitte (2a, 2b) vorstehende Teile der Platte (2) bilden, durch die die äußeren Verbindungen mit dem Filter mittels metallisierter Bereiche (4, 5, 6, 7) hergestellt werden, die auf den vorstehenden Teilen geätzt sind.

## Claims

1. High-frequency electrical filter of any order, characterised in that it comprises, on the one hand, one or more coils formed by a single conductor (1; 8) wound around the same printed circuit board (2) and, on the other hand, capacitive components fixed to the printed circuit board (2) and connected by at least one of their ends to the single conductor (1; 8).

2. Filter according to Claim 1, characterised in that the coil or coils consist of an enamelled copper wire (1), the winding of which around the printed circuit board (2) is carried out in a single operation by making it pass through studs for linking with the other components of the filter which are fixed to the printed circuit.

3. Filter according to Claim 1, characterised in that the turns (8) of the coil or coils are produced as two etched half-turns, one on the front face (10) of the printed circuit board (2) and the other on the rear face (11) and in that the two half-turns (8) are linked by metallised holes (9).

4. Filter according to either of Claims 2 or 3, characterised in that, on the one hand, it exhibits notches (3a, 3b) cut into each edge (2a, 2b) of the printed circuit board (2) defining the space for wiring the coil or coils and, on the other hand, that these notches (2a, 2b) form extended parts of the board (2) by which connections external to the filter are made by means of metallised regions (4, 5, 6, 7) etched on the extended parts.
